# EUROPEAN PATENT SPECIFICATION

(11) **EP 2 755 453 B1**
(45) Date of publication and mention of the grant of the patent: **07.08.2019**
(21) Application number: 12829740.5
(22) Date of filing: 19.04.2012
(51) Int. Cl.: H05H 1/24, C23C 16/452, C23C 16/505, H01L 21/31, C23C 16/503, H01J 37/32

(54) **PLASMA GENERATOR AND CVD DEVICE**
PLASMAGENERATOR UND CVD-VORRICHTUNG
GÉNÉRATEUR DE PLASMA ET DISPOSITIF CVD

(30) Priority: 09.09.2011 JP 2011196908
(43) Date of publication of application: 16.07.2014
(73) Proprietor: Toshiba Mitsubishi-Electric Industrial Systems Corporation, Tokyo 104-0031 (JP)
(72) Inventor: TABATA Yoichiro, Tokyo 108-0073 (JP); WATANABE Kensuke, Tokyo 108-0073 (JP)
(74) Representative: Hoffmann Eitle
(86) International application number: PCT/JP2012/060630
(87) International publication number: WO 2013/035375

(56) References cited:
- EP-A1- 1 475 824
- EP-A1- 2 755 454
- WO-A1-2007/010594
- WO-A1-2009/028084
- JP-A- 2000 012 471
- JP-A- 2001 135 628
- JP-A- 2003 059 924
- JP-A- 2004 149 857
- JP-A- 2004 149 919
- JP-A- 2005 144 318
- JP-A- 2010 047 780
- US-A- 5 246 881
- US-A1- 2010 193 129

## Description

### TECHNICAL FIELD

The present invention relates to a plasma generation apparatus configured to generate, from a source gas, a large amount of plasma excitation gas (active gas, radical gas) with a high energy and a high concentration, and to a structure of a plasma generation apparatus that enables a large amount of the plasma excitation gas generated by the plasma generation apparatus to be efficiently supplied to a CVD apparatus. In more detail, the present invention relates to a plasma generation apparatus and a CVD apparatus that are configured such that a reaction is caused between the plasma excitation gas generated in the plasma generation apparatus and a precursor of metal atoms supplied to the plasma generation apparatus so that modification into functional metal material particles is achieved, and that the functional metal particles obtained by the modification are efficiently led to the CVD apparatus.

### BACKGROUND ART

In the manufacture of a semiconductor device, a thermal CVD (Chemical Vapor Deposition) apparatus, a photo CVD apparatus, or a plasma CVD apparatus is used in a method for forming a highly functional film (such as a highly conductive film with a low impedance that corresponds to a circuit wiring in a semiconductor chip, a highly magnetic film having a function as a wiring coil of a circuit or a function as a magnet in a semiconductor chip, a highly dielectric film having a function as a capacitor of a circuit in a semiconductor chip, and a highly insulating film formed by oxidation or nitriding and having a highly insulating function that causes a less amount of electrical leakage current in a semiconductor chip). Particularly, the plasma CVD apparatus is often used. For example, as compared with the thermal or photo CVD apparatuses, the plasma CVD apparatus is advantageous in that the temperature of film formation can be lowered, the speed of film formation is higher, and a film formation process can be performed in a short time.

For example, to form a gate insulating film such as a nitride film (for example SiON or HfSiON) or an oxide film (SiO₂, HfO₂) on a semiconductor substrate, the following technique that uses the plasma CVD apparatus is generally adopted.

Thus, a gas of NH₃ (ammonia), N₂, O₂, O₃ (ozone), or the like, and a precursor gas of silicon or a hafnium material are directly supplied to a film formation process chamber of a CVD apparatus, for example. Thereby, a chemical reaction caused by heat, a catalyst, or the like, is promoted, and the precursor gas is dissociated. Metal particles resulting from the dissociated precursor are oxidized or nitrided by the added gas of NH₃ (ammonia), N₂, O₂, O₃ (ozone), or the like, and are deposited on a semiconductor wafer that is a processing object. After the deposition, a heat treatment is performed so that a crystal growth occurs. Through the above-described steps, a highly functional film is formed. Accordingly, in the CVD apparatus, high-frequency plasma or microwave plasma is directly generated in the process chamber. Under a state where a wafer substrate is exposed to a radical gas and plasma ions or electrons having a high energy, a highly functional film such as a nitride film or an oxide film is formed on the wafer substrate.

For example, Patent Document 1 may be mentioned as a related art document that discloses a configuration of the plasma CVD apparatus.

In the film formation process within the plasma CVD apparatus, the wafer substrate is directly exposed to plasma, as described above. Therefore, a problem always occurs that the wafer substrate is largely damaged by plasma (ions or electrons) to cause a deterioration in the performance of a semiconductor function.

In contrast, in the film formation process using the thermal or photo CVD apparatuses, the wafer substrate is not damaged by plasma (ions or electrons), so that a highly functional film such as a nitride film or an oxide film is formed with a high quality. However, such a film formation process involves a problem that it is difficult to provide a nitrogen radical gas source or an oxygen radical source with a high concentration and a large amount, and consequently a very long time is required for the film formation.

In the recent thermal or photo CVD apparatuses, a high-concentration NH₃ or O₃ gas, which can be readily dissociated by radiation of heat or light, is used as the source gas, and a thermal catalyst is provided in a CVD chamber. Accordingly, in the thermal or photo CVD apparatuses, a catalytic action promotes dissociation of the gas in the chamber, and a time period for formation of the highly functional film such as a nitride film or an oxide film can be shortened. However, this method faces difficulties in considerably improving the time period for film formation.

Therefore, as an apparatus that can reduce damages to the wafer substrate caused by plasma and that can shorten a time period for the film formation, a film formation processing apparatus of remote plasma type may be mentioned (for example, see Patent Document 2).

In a technique of the Patent Document 2, a plasma generation region and an object processing region are separated from each other by a partition (plasma confinement electrode). More specifically, in the technique according to the Patent Document 2, the plasma confinement electrode is provided between a high-frequency application electrode and a counter electrode on which a wafer substrate is placed, to thereby allow only neutral activated species to be supplied onto the wafer substrate.

### PRIOR-ART DOCUMENTS

### PATENT DOCUMENTS

Patent Document 1: Japanese Patent Application Laid-Open No. 2007-266489
Patent Document 2: Japanese Patent Application Laid-Open No. 2001-135628

Applicant's co-pending EP-2.755.454 claims an earlier priority date than the present application, but is published after the filing date of the present application, such that EP-2.755.454 is not relevant to the question of inventive step.

US 2010/0193129 discloses an apparatus for generating a dielectric-barrier discharge gas.

### SUMMARY OF THE INVENTION

### PROBLEMS TO BE SOLVED BY THE INVENTION

However, in the technique according to the Patent Document 2 relating to a film formation on a wafer for use in a semiconductor, damages to a processing object material (wafer substrate) caused by plasma is not completely suppressed, and a configuration of the apparatus is complicated.

Additionally, the conventional CVD apparatus is configured such that a metal precursor gas is directly supplied into a CVD chamber in which a film formation process for forming a highly functional insulating film is performed. Directly supplying a metal precursor gas into a CVD chamber is not desirable because the structure of the CVD chamber itself and a control operation including operation conditions are complicated.

It is demanded that a large amount of functional metal material particle gas, which is nitrided, oxidized, or the like, be efficiently outputted in a case where a highly functional insulating film is formed with use of a film formation process apparatus of remote plasma type.

Therefore, an object of the present invention is to provide a plasma generation apparatus configured to generate a plasma excitation gas while preventing the structure of a CVD chamber from being complicated. Another object of the present invention is to provide a plasma generation apparatus configured to efficiently output a large amount of functional metal material particle gas, for formation of a highly functional film on a processing object material with use of the plasma excitation gas. Still another object of the present invention is to provide a CVD apparatus that, by using the plasma generation apparatus, enables formation of a highly functional film having a high quality, with prevention of occurrence of damage to the processing object material caused by plasma.

### MEANS FOR SOLVING THE PROBLEMS

To attain the objects, a plasma generation apparatus according to the present invention includes an electrode cell; a power source part configured to apply an AC voltage to the electrode cell; a housing that encloses the electrode cell; and a source gas supply part configured to supply a source gas from the outside of the housing into the housing. The electrode cell includes: a first electrode; a second electrode facing the first electrode so as to form a discharge space; a dielectric arranged on at least either one of a main surface of the first electrode facing the discharge space and a main surface of the second electrode facing the discharge space; and a pass-through formed in a central portion of the electrode cell in a plan view, the pass-through penetrating the electrode cell with respect to a facing direction in which the first electrode and the second electrode face each other. The plasma generation apparatus further includes: an insulating tube having a cylindrical shape and arranged in the pass-through, the insulating tube including an ejection hole that is formed in a side surface of the cylindrical shape; and a precursor supply part connected to a hollow portion of the insulating tube from the outside of said housing and configured to supply a metal precursor.

A CVD apparatus according to the present invention includes: a plasma generation apparatus; and a CVD chamber connected to the plasma generation apparatus. The plasma generation apparatus includes: an electrode cell; a power source part configured to apply an AC voltage to the electrode cell; a housing that encloses the electrode cell; and a source gas supply part configured to supply a source gas from the outside of the housing into the housing. The electrode cell includes: a first electrode; a second electrode facing the first electrode so as to form a discharge space; a dielectric arranged on at least either one of a main surface of the first electrode facing the discharge space and a main surface of the second electrode facing the discharge space; and a pass-through formed in a central portion of the electrode cell in a plan view, the pass-through penetrating the electrode cell with respect to a facing direction in which the first electrode and the second electrode face each other. The plasma generation apparatus further includes: an insulating tube having a cylindrical shape and arranged in the pass-through, the insulating tube including an ejection hole that is formed in a side surface of the cylindrical shape; and a precursor supply part connected to a hollow portion of the insulating tube from the outside of said housing and configured to supply a metal precursor. The CVD chamber is connected to an end portion of the insulating tube.

### EFFECTS OF THE INVENTION

The plasma generation apparatus according to the present invention includes an electrode cell; a power source part configured to apply an AC voltage to the electrode cell; a housing that encloses the electrode cell; and a source gas supply part configured to supply a source gas from the outside of the housing into the housing. The electrode cell includes: a first electrode; a second electrode facing the first electrode so as to form a discharge space; a dielectric arranged on at least either one of a main surface of the first electrode facing the discharge space and a main surface of the second electrode facing the discharge space; and a pass-through formed in a central portion of the electrode cell in a plan view, the pass-through penetrating the electrode cell with respect to a facing direction in which the first electrode and the second electrode face each other. The plasma generation apparatus further includes: an insulating tube having a cylindrical shape and arranged in the pass-through, the insulating tube including an ejection hole that is formed in a side surface of the cylindrical shape; and a precursor supply part connected to a hollow portion of the insulating tube and configured to supply a metal precursor.

Accordingly, a plasma excitation gas comes into contact with a metal precursor gas, and thereby the metal precursor gas is dissociated into metal atoms in the hollow portion. A chemical reaction between the metal atoms resulting from the dissociation and the plasma excitation gas occurs in the hollow portion. As a result, a large amount of functional metal material particle gas which is nitrided, oxidized, or the like, can be efficiently generated in the hollow portion.

The plasma excitation gas is outputted in such a manner that the plasma excitation gas is ejected not to the CVD chamber but to a vacuumed space provided in the plasma generation apparatus that generates the plasma excitation gas. Additionally, the plasma excitation gas is brought into contact with the supplied metal precursor gas in a crossing manner.

Accordingly, a larger amount of plasma excitation gas having a higher concentration can be generated, brought into contact with, and react with the metal precursor gas. Therefore, a larger amount of the functional metal material particle gas modified through the reaction can be generated more efficiently.

The metal precursor gas is not directly supplied to the CVD chamber. The functional metal material particle gas that has been modified is generated in the plasma generation apparatus, and outputted to the film formation CVD apparatus.

Thus, it is not necessary that a function for modification into the functional metal material particle gas by means of plasma is provided in the CVD chamber side. This can prevent complication of the structure and controllability. Thus, a film with a higher quality can be obtained.

These and other objects, features, aspects and advantages of the present invention will become more apparent from the following detailed description of the present invention when taken in conjunction with the accompanying drawings.

### BRIEF DESCRIPTION OF THE DRAWINGS

[FIG. 1] A cross-sectional view showing an overall configuration of a CVD apparatus 300 according to an embodiment 1.
[FIG. 2] A cross-sectional view showing, on an enlarged scale, a configuration of an electrode cell.
[FIG. 3] A perspective view showing, on an enlarged scale, a configuration of a gas output flange 14c.
[FIG. 4] A cross-sectional view showing an overall configuration of a CVD apparatus 300 according to an embodiment 2.
[FIG. 5] A cross-sectional view showing, on an enlarged scale, an internal configuration of an insulating tube 21 according to the embodiment 2.
[FIG. 6] A cross-sectional view showing, on an enlarged scale, an internal configuration of an insulating tube 21 according to an embodiment 3.

### EMBODIMENT FOR CARRYING OUT THE INVENTION

In the following, a specific description will be given to the present invention with reference to the drawings that illustrate embodiments of the present invention.

### <Embodiment 1>

In this embodiment, application of a plasma apparatus according to the present invention to a CVD apparatus will be described.

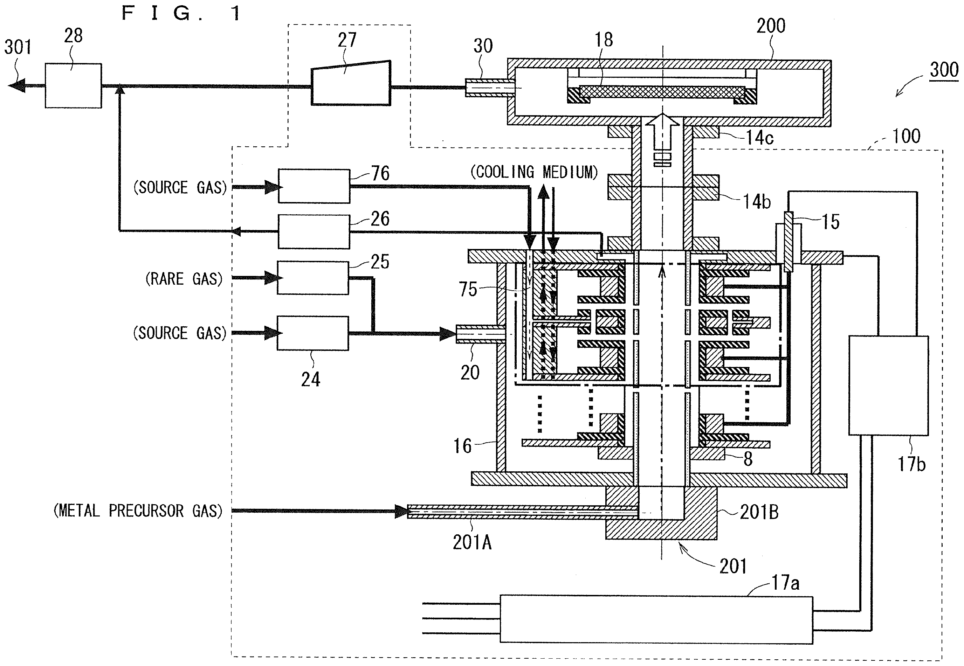

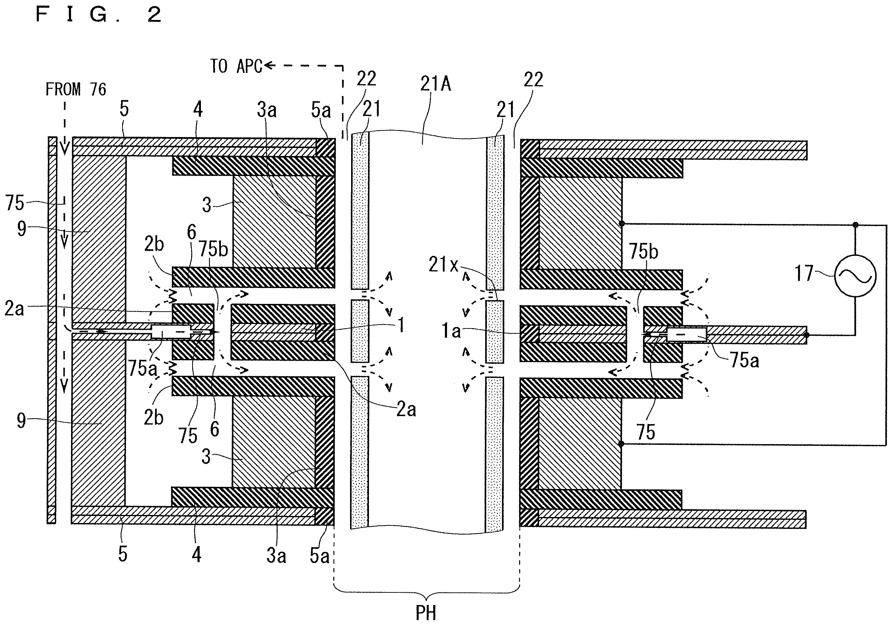

FIG. 1 is a cross-sectional view showing a configuration of a CVD apparatus 300 according to this embodiment. FIG. 2 is a cross-sectional view showing, on an enlarged scale, a region enclosed by the broken line in FIG. 1 (FIG. 2 discloses a detailed configuration of a cross-section of an electrode cell).

As shown in FIG. 1, the CVD apparatus 300 includes a plasma generation apparatus 100, a CVD chamber 200, and an exhaust gas decomposition processor 28.

Firstly, a configuration of the plasma generation apparatus 100 according to the present invention will be described.

As shown in FIG. 1, in the plasma generation apparatus 100, a plurality of electrode cells are stacked in the vertical direction of FIG. 1. In the cross-sectional view on an enlarged scale shown in FIG. 2, two electrode cells are illustrated. A configuration of the electrode cells having a stacked structure will be described with reference to FIG. 2.

Each electrode cell has a doughnut shape in a plan view, that is, when seen along the vertical direction of FIGS. 1 and 2. In other words, the electrode cell has a substantially disk-like outer shape, and a pass-through PH is formed in a central portion of the electrode cell. The pass-through PH penetrates the electrode cell in the vertical direction (the direction in which the electrode cells are stacked).

Each electrode cell includes a low-voltage electrode 1, dielectrics 2a, 2b, a high-voltage electrode 3, an insulating plate 4, and a high-pressure cooling plate 5. The plurality of electrode cells are stacked in the vertical direction of FIGS. 1 and 2 (the direction in which the high-voltage electrode 3 and the low-voltage electrode 1 are opposed to each other).

In a plan view, each electrode cell has a circular shape with the pass-through PH, as described above. Therefore, each of the members 1, 2a, 2b, 3, 4, and 5 is formed as a plate whose other shape is a circular shape in a plan view. The above-mentioned pass-through PH is provided in a central portion of each of the members 1, 2a, 2b, 3, 4, and 5.

As shown in FIG. 2, an AC voltage from an AC power source 17 is applied to the low-voltage electrode 1 and the high-voltage electrode 3. The low-voltage electrode 1, as well as a connection block 9, the high-pressure cooling plate 5, and a housing 16 which will be described later, is set to a fixed potential (ground potential).

The dielectric 2a is arranged on a main surface of the low-voltage electrode 1. To be more specific, one main surface of the dielectric 2a is in contact with the main surface of the low-voltage electrode 1. A conductive material is, for example, applied, printed, or vapor-deposited on the one main surface of the dielectric 2a. The dielectric 2b is arranged so as to face the dielectric 2a with a discharge space 6 being interposed between the dielectric 2b and the dielectric 2a. To be more specific, the other main surface of the dielectric 2a faces one main surface of the dielectric 2b with interposition of the discharge space 6 therebetween. A plurality of spacers (not shown) are interposed between the dielectric 2a and the dielectric 2b. The spacers hold and fix a gap of the discharge space 6. The dimension of the discharge space 6 with respect to the vertical direction of FIG. 2 is, for example, about 0.05 mm to several mm.

The high-voltage electrode 3 is arranged on the other main surface of the dielectric 2b. To be more specific, one main surface of the high-voltage electrode 3 is in contact with the other main surface of the dielectric 2b. A conductive material is, for example, applied, printed, or vapor-deposited on the other main surface of the dielectric 2b. One main surface of the insulating plate 4 is in contact with the other main surface of the high-voltage electrode 3. The high-pressure cooling plate 5 is in contact with the other main surface of the insulating plate 4. This specification illustrates one example that adopts a stack configuration including the insulating plate 4 and the high-pressure cooling plate 5, but, needless to say, a stack configuration not including the insulating plate 4 and the high-pressure cooling plate 5 is also adoptable.

The dielectric 2a on which the conductive material is applied or the like, the spacers (not shown), and the dielectric 2b on which the conductive material is applied or the like, may be configured as an integrated body.

As shown in FIG. 2, in each electrode cell, the low-voltage electrode 1 and the high-voltage electrode 3 face each other with interposition of the dielectrics 2a, 2b and the discharge space 6 therebetween. That is, the dielectrics 2a, 2b are arranged on the main surface of the low-voltage electrode 1 facing the discharge space 6 and the main surface of the high-voltage electrode 3 facing the discharge space 6, respectively. In this embodiment, a configuration including the dielectrics 2a, 2b is adopted, because a dielectric material having a high resistance to sputtering and high non-conductive properties is an effective material for both surfaces of the discharge space 6 where a discharge occurs. Instead of the configuration shown in FIG. 2, only either one of the dielectric 2a and the dielectric 2b can be omitted.

The electrode cell having the configurations 1, 2a, 2b, 3, 4, and 5 has the pass-through PH penetrating therethrough in the direction in which these configurations are stacked, as described above. The pass-throughs PH formed in the electrode cells are connected in the direction in which the electrode cells are stacked, to form a single through hole. In this specification, the single through hole will be referred to as a "continuous through hole". As seen from the description given above, the continuous through hole extends in the stacking direction.

In this embodiment, as shown in FIG. 2, the electrode cells that neighbor each other with respect to the vertical direction share one low-voltage electrode 1 as a common component part (the two electrode cells that share the one low-voltage electrode 1 as a common component part will be referred to as a electrode cell pair). Adoption of such a configuration in which the low-voltage electrode 1 is shared between the electrode cells can reduce the number of parts. In a case where reduction in the number of parts is not purposed, a configuration in which the low-voltage electrode 1 is not shared is adoptable.

In the configuration shown in FIG. 2, a structure of one electrode cell pair is shown, and a plurality of the electrode cell pairs are stacked in the vertical direction of FIG. 2. A connection block 9 is interposed between each of the low-voltage electrodes 1 and each of the high-pressure cooling plates 5. That is, the connection block 9 is placed at the lateral side of each electrode cell. The presence of the connection block 9 enables the dimension of a portion of each electrode cell between the low-voltage electrode 1 and the high-pressure cooling plate 5 to be kept at a constant value. The connection block 9 is not placed over the entire lateral side of the electrode cell, but placed only at a part of the lateral side (at the left side of the cross-sectional view shown in FIG. 2) of the electrode cell, as shown in FIG. 2.

In the plasma generation apparatus 100, as shown in FIG. 2, an insulating tube 21 is placed within the above-mentioned continuous through hole. The insulating tube 21 has a cylindrical shape with a hollow portion 21A penetrating therethrough in the vertical direction of FIG. 2. The insulating tube 21 is arranged in the continuous through hole such that the cylindrical axis direction of the insulating tube 21 is in parallel with the direction in which the electrode cells are stacked (more specifically, the axial direction of the continuous through hole is coincident with the cylindrical axis direction of the insulating tube 21).

A plurality of fine ejection holes (nozzle holes) 21x are provided in a side surface of the insulating tube 21. In the exemplary configuration shown in FIG. 2, the ejection holes 21x are provided in the insulating tube 21 such that each of them faces the discharge space 6. The diameter of an opening of each ejection hole 21x is smaller than the diameter of the discharge space 6 with respect to the stacking direction. The insulating tube 21 is made of quartz, alumina, or the like.

In the example described above, the insulating tube 21 is configured as a single insulating tube having a plurality of fine ejection holes 21x. Instead, however, the insulating tube 21 may be configured such that ring-shaped insulating tubes each having a plurality of fine ejection holes 21x formed therein are stacked in the pass-throughs PH.

From the viewpoint of setting a desired pressure difference between the discharge space 6 and the hollow portion 21A, it is preferred that the diameter of the ejection hole 21x is about 0.05 mm to 0.3 mm and the length of the ejection hole 21x (which can be regarded as the thickness of the insulating tube 21) is about 0.3 mm to 3 mm.

As shown in FIG. 2, a circumferential surface facing the inside the continuous through hole and an outer circumferential surface of the insulating tube 21 are spaced apart from each other at a predetermined interval. In other words, a pipe passage 22 is provided between the side surface of the electrode cell facing the pass-throughs PH (or the continuous through hole) and the side surface of the insulating tube 21, as shown in FIG. 2. The pipe passage 22 has an annular shape when seen along the vertical direction of FIG. 2. Thus, the side surface of the electrode cell facing the pass-throughs PH (or the continuous through hole) in a plan view serves as an outer circumference while the side surface of the insulating tube 21 in a plan view serves as an inner circumference, and a space between the outer circumference and the inner circumference serves as the pipe passage 22 having the annular shape in a plan view.

The pipe passage 22 is connected to the discharge space 6 at the outer circumference side. An end portion of the pipe passage 22 extends through an upper surface of the housing 16, to be connected to an auto pressure controller (APC) 26 provided outside the housing 16 as will be described later (see FIG. 1).

The high-pressure cooling plate 5, the high-voltage electrode 3, and the low-voltage electrode 1 are made of a conductive material. An insulator 5a is provided in a portion of the high-pressure cooling plate 5 facing the insulating tube 21. An insulator 3a is provided in a portion of the high-voltage electrode 3 facing the insulating tube 21. An insulator 1a is provided in a portion of the low-voltage electrode 1 facing the insulating tube 21.

Thus, in each electrode cell, a portion facing the insulating tube 21, including the members 4, 2a, and 2b, is entirely made of an insulating material. Therefore, the whole of an inner surface of the pipe passage 22 formed in the continuous through hole of each electrode cell has insulating properties. This can prevent occurrence of discharge (abnormal discharge) at a place within the pipe passage 22 other than the discharge space 6.

A passage (not shown) through which a cooling medium passes is formed in each of the connection blocks 9 stacked in the vertical direction of FIGS. 1 and 2. A passage (not shown) is also formed within the high-pressure cooling plate 5 and within the low-voltage electrode 1. The cooling medium, which is supplied from the outside, flows through the passage formed within the connection block 9, circulates through the passage formed within each high-pressure cooling plate 5 and the passage formed within each low-voltage electrode 1, and is outputted to the outside through another passage formed within the connection block 9.

The cooling medium whose temperature has been adjusted to a constant temperature is caused to flow through the passage formed within the high-pressure cooling plate 5, and thereby the high-voltage electrode 3 is cooled to the constant temperature via the insulating plate 4. The cooling medium whose temperature has been adjusted to a constant temperature is caused to flow through the passage formed within the low-voltage electrode 1, and thereby the low-voltage electrode 1 itself is cooled to and kept at the constant temperature, so that the temperature of a gas within the discharge space 6 can be indirectly kept at the constant temperature, too. The temperature of the cooling medium is adjusted to the constant temperature within a range of, for example, several °C to 25°C.

In accordance with, for example, the type of a gas supplied to the discharge space 6, a liquid whose temperature has been adjusted to a constant temperature within a temperature range of the relatively high temperature (for example, about 100°C to 200°C) may be adopted instead of the cooling medium. The liquid, which is supplied from the outside, flows through the passage formed within the connection block 9, circulates through the passage formed within each high-pressure cooling plate 5 and the passage formed within each low-voltage electrode 1, and is outputted to the outside through another passage formed within the connection block 9.

The liquid whose temperature has been adjusted to a constant temperature is caused to flow through the passages formed within the connection block 9, the low-voltage electrode 1, and the like, and thereby the connection block 9, the low-voltage electrode 1, and the like, are kept at the constant temperature. Furthermore, the temperature of a gas within the discharge space 6 is indirectly kept at the constant temperature, too, via the low-voltage electrode 1.

In the plasma generation apparatus 100 according to the present invention, a pipe passage 75 for supplying the source gas to the discharge space 6 is placed. The pipe passage 75 is not connected to a space within the housing 16 where the electrode cell is not arranged, and directly connects the outside of the housing 16 to the discharge space 6. That is, the gas flowing through the pipe passage 75 is not supplied to an outer circumferential region of the electrode cell within the housing 16, but directly supplied to each discharge space 6 of each electrode cell.

As shown in FIGS. 1 and 2, the pipe passage 75 extends from an upper portion of the housing 16 to the inside of each connection block 9. The pipe passage 75 branches at each low-voltage electrode 1, so that the pipe passage 75 is arranged within each low-voltage electrode 1.

The pipe passage 75 includes a buffer 75a. The buffer 75a is arranged so as to extend around within the low-voltage electrode 1. The dimension of the buffer 75a with respect to the stacking direction is larger than the dimension of another portion of the pipe passage 75 arranged within the low-voltage electrode 1 with respect to the stacking direction.

The pipe passage 75 includes an ejection port 75b. The ejection port 75b penetrates the low-voltage electrode 1 and the dielectric 2a that is in contact with the low-voltage electrode 1. The ejection port 75b is connected to the discharge space 6 of the electrode cell. As shown in FIG. 2, the buffer 75a and the ejection port 75b are connected to each other by the pipe passage 75.

Each of the low-voltage electrode 1 and the dielectric 2a has a circular shape in a plan view. In each low-voltage electrode 1 and each dielectric 2a, a plurality of the ejection ports 75b are arranged along the circumferential direction of the circular shape. It is desirable that the interval of the ejection ports 75b arranged long the circumferential direction is constant. The ejection port 75b faces the discharge space 6, and it is desirable that the ejection port 75b is arranged as close to the outside of the discharge space 6 as possible (in other words, close to the outer circumference side of the electrode cell where the insulating tube 21 is not provided). This enables the active gas, the metal precursor gas, and the like, to be uniformly ejected from the ejection port 75b into each discharge space 6. The ejected gas propagates radially inward from the outer circumference to the inner side (to the insulating tube 21 side) of a discharge surface.

Needless to say, the ejection ports 75b arranged along the circumferential direction are connected to one another via the pipe passages 75 and the buffers 75a formed so as to extend around within the low-voltage electrode 1.

The pipe passage 75 having the above-described configuration is connected to a gas MFC (Mass Flow Controller) 76 arranged in the outside of the housing 16.

As seen from the above-described configuration of the pipe passage 75, various gases outputted from the gas MFC 76 enters the inside of the housing 16 from the upper portion thereof, propagates within each connection block 9, branches at each low-voltage electrode 1, and propagates through each low-voltage electrode 1. Then, the gas permeates the buffer 75a, and then is supplied from the ejection port 75b into the discharge space 6 without contacting the outer circumferential region of the electrode cell within the housing 16.

The passage through which the above-described cooling medium (the liquid whose temperature has been adjusted) passes and the pipe passage 75 are separate and different paths.

The pipe passage 75 (including the parts 75a and 75b) for directly supplying the source gas from the outside of the housing 16 into the discharge space 6 without contacting a space within the housing where the electrode cell is not arranged has, on its inner surface (inner wall), a passive film causing no corrosion by a chemical reaction with respect to an active gas or a platinum film or a gold film having a high resistance to a chemical reaction.

To ensure the airtightness of each passage and the pipe passage 75, airtightening members such as O-rings are arranged in a connection portion connecting the connection block 9 to the high-pressure cooling plate 5 and in a connection portion connecting the connection block 9 to the low-voltage electrode 1.

As shown in FIG. 1, the plasma generation apparatus 100 includes the housing 16. The housing 16 is made of, for example, aluminum or SUS. The plurality of electrode cells are arranged in a stacked manner within the housing 16 in which the airtightness is ensured. Thus, a stack of the electrode cells is covered with an upper surface, a lower surface, and a side surface of the housing 16. A space is present between the side surface of the housing 16 and the side surface of each electrode cell. A space is also present between a bottom surface of the housing 16 and a lowermost portion of each electrode cell. As shown in FIG. 1, the stack of electrode cells is firmly fixed to the upper surface of the housing 16 by means of a fastening member 8.

The plasma generation apparatus 100 includes the AC power source 17 shown in FIG. 2. As shown in FIG. 1, the AC power source 17 includes an inverter 17a and a high-voltage transformer 17b.

The inverter 17a performs a frequency conversion process on an AC voltage of 60Hz inputted thereto, and as a result outputs an AC voltage of 15kHz to the high-voltage transformer 17b. The high-voltage transformer 17b performs a voltage step-up process on an AC voltage of 200 to 300V inputted thereto, and as a result outputs an AC voltage of several kV to several tens of kV.

One end of the high-voltage transformer 17b is connected to each high-voltage electrode 3 via an electricity supply terminal 15. The other end of the high-voltage transformer 17b is connected to the housing 16. The housing 16, the high-pressure cooling plate 5, the connection block 9, and the low-voltage electrode 1 are electrically connected, and set to a fixed potential (ground potential). As seen from the configuration shown in FIG. 2, the high-pressure cooling plate 5 and the high-voltage electrode 3 are electrically insulated from each other by the insulating plate 4.

As shown in FIG. 1, the plasma generation apparatus 100 includes a gas supply part 20, a gas MFC 24, and a sub gas MFC 25. The plasma generation apparatus 100 further includes the gas MFC 76, as described above.

In this embodiment, the gas MFC 76 outputs an active gas as the source gas. In accordance with a material of a film to be formed on a processing object material 18 placed in the CVD chamber 200, an active gas such as an ozone gas, an ammonia gas, or a nitrogen oxide gas may be supplied from the gas MFC 76 to the pipe passage 75. The active gas may be supplied together with an inert gas.

In this embodiment, a metal precursor (precursor) gas for obtaining a gas of functional metal material particles (a highly functional insulating film) that are nitrided, oxidized, or the like, may be supplied as the source gas from the gas MFC 76. A metal precursor gas obtained by vaporization of a metal such as hafnium may be outputted from the gas MFC 76 to the pipe passage 75. The metal precursor gas may be supplied together with an inert gas.

The gas supply part 20 is provided in the side surface of the housing 16. The gas supply part 20 supplies a predetermined gas from the outside of the housing 16 into the housing 16. More specifically, the predetermined gas passes through the gas supply part 20, and is supplied to an outer circumferential portion of the electrode cell (that is, a region within the housing 16 in which the stack of electrode cells is not arranged).

An inert gas such as a nitrogen gas and an oxygen gas is supplied as the source gas from the gas MFC 24. A rare gas (such as a helium gas and an argon gas) is supplied from the sub gas MFC 25. As shown in FIG. 1, in a pipe passage provided halfway, the source gas and the rare gas are mixed. Then, the source gas and the rare gas are supplied to the gas supply part 20.

It may be acceptable that the gas MFC 24 supplies the source gas into the housing 16 for a reaction in the discharge space 6, or that the gas MFC 24 supplies the predetermined gas as a carrier gas into the housing 16.

Although the gas supply part 20 supplies the source gas together with the rare gas into the housing 16 in this embodiment, it may be also possible that only the source gas is supplied to the housing 16.

As shown in FIG. 1, the plasma generation apparatus 100 includes the auto pressure controller 26. As described above, the auto pressure controller 26 is connected to the pipe passage 22 shown in FIG. 2. Moreover, as described above, the annular pipe passage 22 is, at the outer circumference side thereof, connected to the discharge space 6. This configuration enables each discharge space 6 to be kept at a constant pressure by means of the auto pressure controller 26 via the pipe passage 22. For example, the auto pressure controller 26 keeps each discharge space 6 at a constant pressure within a pressure range of 0.03MPa (mega Pascal) to 0.3MPa.

In this embodiment, the plasma generation apparatus 100 includes a pressure reducer 27. In the configuration shown in FIG. 1, the pressure reducer 27 is connected to the hollow portion 21A of the insulating tube 21 via the CVD chamber 200. For example, a vacuum pump is adoptable as the pressure reducer 27. This configuration enables the pressure reducer 27 to reduce the pressure in the hollow portion 21A of the insulating tube 21 to a pressure lower than the atmospheric pressure (for example, 1 to 5000Pa (Pascal)). In the exemplary configuration shown in FIG. 1, as described above, the pressure reducer 27 is connected to the CVD chamber 200, too. Therefore, the pressure in the CVD chamber 200 is also reduced to, for example, about 1 to 5000Pa by means of the pressure reducer 27.

In the plasma generation apparatus 100 having the above-described configuration, an end portion of the insulating tube 21 is connected to an upper surface of the CVD chamber 200 (a surface thereof facing a processing surface of the processing object material 18) via two gas output flanges 14b, 14c (see FIG. 1). Thus, the gas output flanges 14b, 14c serve as joints between the hollow portion 21A of the insulating tube 21 and the CVD chamber 200. As seen from the above-described configuration, a gas and the like existing in the hollow portion 21A of the insulating tube 21 can be supplied into the CVD chamber 200 via the gas output flanges 14b, 14c (a stream of the gas can be generated by a suction force of the pressure reducer 27).

The processing object material 18 such as a semiconductor wafer is placed in a reaction chamber within the CVD chamber 200. In the CVD chamber 200, the processing object material 18 is exposed to a gas propagated from the hollow portion 21A of the insulating tube 21. Thereby, a desired highly functional film can be formed on a surface of the processing object material 18.

An exhaust gas output port 30 is provided in a side surface of the CVD chamber 200. The exhaust gas output port 30 is connected to the pressure reducer 27. The pressure reducer 27 reduces the pressure within the hollow portion 21A of the insulating tube 21 and the pressure within the CVD chamber 200. This pressure reduction operation can generate a stream of a gas, particles, and the like, flowing from the hollow portion 21A of the insulating tube 21 → the gas output flanges 14b, 14c → the inside of the CVD chamber 200 → the exhaust gas output port 30 → the pressure reducer 27.

The plasma generation apparatus 100 according to the present invention further includes a precursor supply part 201, as shown in FIG. 1. The precursor supply part 201 is connected to the hollow portion 21A of the insulating tube 21, and configured to supply the metal precursor from the outside of the housing 16 into the hollow portion 21A. The precursor supply part 201 includes a supply pipe passage 201A and a flange portion 201B.

As shown in FIG. 1, the insulating tube 21 is arranged so as to penetrate the fastening member 8 and also penetrate the lower surface of the housing 16. The insulating tube 21 is exposed in a space within the housing 16 at a position between the fastening member 8 and the lower surface of the housing 16. This exposed portion of the insulating tube 21 has no ejection hole 21x formed therein.

As described above, an end portion of the insulating tube 21 is exposed from the lower surface of the housing 16 (that is, the hollow portion 21A of the insulating tube 21 faces the outside from the lower surface of the housing 16). The flange portion 201B is firmly fixed to the lower surface of the housing 16 at the outside of the housing 16 such that the flange portion 201B is connected to the hollow portion 21A.

The supply pipe passage 201A is connected to a side surface of the flange portion 201B. A metal precursor gas is supplied from the supply pipe passage 201A. The metal precursor gas supplied from the supply pipe passage 201A is, through the flange portion 201B, supplied to the hollow portion 21A of the insulating tube 21 that has been vacuumed.

As shown in FIG. 1, the pressure reducer 27 and the auto pressure controller 26 are connected to the exhaust gas decomposition processor 28. Therefore, a gas and the like outputted from the pressure reducer 27 and the auto pressure controller 26 are subjected to a decomposition process by the exhaust gas decomposition processor 28. The gas on which the decomposition process has been performed is, as a process gas 301, exhausted from the exhaust gas decomposition processor 28.

Next, an operation of the CVD apparatus 300 according to this embodiment, including an operation of the plasma generation apparatus 100, will be described.

Referring to FIG. 1, a source gas such as an active gas and a metal precursor gas is supplied from the gas MFC 76. The supplied source gas is inputted to the pipe passage 75, passes through the pipe passage 75, and is directly supplied to each discharge space 6 (that is, the source gas is supplied to the discharge space 6 without contacting a space within the housing 16 other than the discharge space 6).

The gas MFC 24 supplies the source gas that contributes to a reaction caused in the discharge space 6, a gas that functions as a carrier gas, or the like. The sub gas MFC 25 supplies a rare gas. The source gas, or the like, and the rare gas thus supplied join and mix together before they are inputted to the gas supply part 20. The mixed gas is supplied from the gas supply part 20 into the housing 16 of the plasma generation apparatus 100 (into a region within the housing 16 where the stack of electrode cells is not arranged).

The mixed gas thus supplied permeates the inside of the housing 16. The mixed gas having permeated the inside of the housing 16 enters the discharge space 6 formed in each electrode cell from the outer circumferential side of the electrode cell whose outer shape is circular in a plan view.

As shown in FIG. 2, in each electrode cell, the AC power source 17 applies a high-frequency AC voltage between the high-voltage electrode 3 and the low-voltage electrode 1. Application of the AC voltage to the electrodes 1, 3 causes dielectric barrier discharge (silent discharge) with high-frequency plasma to uniformly occur in the discharge space 6 of each electrode cell under a constant pressure that is near the atmospheric pressure.

In the discharge space 6 where the dielectric barrier discharge is occurring, the source gas and the like are supplied as described above. As a result, due to the dielectric barrier discharge, a discharge dissociation reaction of the supplied source gas is caused in the discharge space 6.

For example, a case is assumed in which an active gas such as an ozone gas, an ammonia gas, or a nitrogen oxide gas is supplied as a source gas via the pipe passage 75 while an inert gas of oxygen, nitrogen, or the like, is supplied as a source gas via the gas supply part 20.

In this case, due to the dielectric barrier discharge occurring in the discharge space 6, a plasma excitation gas is generated in a large amount and with a high concentration. The plasma excitation gas is, as a result of dissociation caused by the discharge, generated from the supplied inert gas of oxygen, nitrogen, or the like, and the active gas such as ozone or an ammonia gas. In a case where an active gas is supplied as the source gas via the pipe passage 75, as compared with a case where an inert gas of oxygen, nitrogen, or the like, is supplied, dissociation into the plasma excitation gas due to the discharge is likely to occur, which results in generation of a large amount of plasma excitation gas with a high concentration. Accordingly, the large amount of plasma excitation gas with a high concentration can be outputted to the processing object material 18.

In this case, the plasma excitation gas is generated from the supplied inert gas due to the dielectric barrier discharge occurring in the discharge space 6. Since an active gas is supplied as the source gas via the pipe passage 75, the processing object material 18 can be exposed to a high-concentration active gas.

The auto pressure controller 26 keeps each discharge space 6 to a constant pressure Pa, and the pressure reducer 27 such as a vacuum pump sets a pressure Pb in the hollow portion 21A of the insulating tube 21 to be lower than the pressure Pa in the discharge space 6 (Pa>Pb).

For example, the pressure Pa in the discharge space 6 is set to be near the atmospheric pressure (100kPa), and the pressure Pb in the hollow portion 21A of the insulating tube 21 is set to be a vacuum pressure that is equal to or lower than 40kPa (about 300 Torr).

Since the pressure Pb in the hollow portion 21A is reduced to a value lower than the atmospheric pressure by the pressure reducer 27, a pressure difference (Pa-Pb) occurs between the discharge space 6 and the hollow portion 21A with interposition of the fine ejection holes 21x of the insulating tube 21. This pressure difference can generate a stream of the gas ejected from the discharge space 6 to the hollow portion 21A to occur at the ejection holes 21x.

Adoption of a configuration in which the pressure difference (Pa-Pb) is caused under a state where the fine ejection holes 21x are provided in a thin wall of the insulating tube 21 can extremely shorten a time period during which the plasma excitation gas generated in each discharge space 6 is in contact with a wall surface near the fine ejection hole 21x, and can reduce the contact area between the gas and a portion around the ejection hole 21x as small as possible.

The ejection hole 21x in the shape of a nozzle ejects the plasma excitation gas to the hollow portion 21A by using an adiabatic expansion effect. Accordingly, the amount of attenuation of the plasma excitation gas due to collision of the plasma excitation gas with an inner wall of the ejection hole 21x and the amount of attenuation of the plasma excitation gas due to heat generation are suppressed as small as possible. Thus, the plasma excitation gas, with suppression of the amount of attenuation thereof, can be led to the hollow portion 21A at a high speed.

Thus, the gases, which have been supplied into the discharge space 6 of the electrode cell whose outer shape is circular in a plan view, move radially inward to the central portion of the electrode cell. During this movement, the gasses are exposed to the dielectric barrier discharge, so that the plasma excitation gas is generated. The generated plasma excitation gas is ejected (join together) into the hollow portion 21A of the insulating tube 21 placed in the central portion of the electrode cell under a state where the amount of attenuation of these gasses are suppressed as much as possible. Then, the plasma excitation gases join together in the hollow portion 21A.

In the plasma apparatus 100 according to the present invention, a metal precursor gas is supplied from the outside of the housing 16 to the hollow portion 21A of the insulating tube 21 via the precursor supply part 201.

Thus, a contact between the plasma excitation gas ejected through the ejection holes 21x of the insulating tube 21 and the metal precursor gas supplied from the precursor supply part 201 occurs in the hollow portion 21A of the insulating tube 21. The contact of the plasma excitation gas with the metal precursor gas causes the metal precursor gas to dissociate into metal atoms within the hollow portion 21A. Additionally, in the hollow portion 21A, a chemical reaction occurs between the metal atoms resulting from the dissociation and the plasma excitation gas, so that a large amount of a functional metal material particle gas which is nitrided, oxidized, or the like, is efficiently generated.

The type of the metal precursor gas that is supplied from the precursor supply part 201 is changeable, which enables various kinds of metal precursor gases to be dissociated into a metal particle gas. As a result of a chemical reaction between the metal particle gas and the plasma excitation gas, the metal particle gas itself is modified into functional metal material particles which are nitrided, oxidized, or the like. The functional metal material particle gas moves within the hollow portion 21A.

Due to the suction force exerted by the pressure reducer 27, the functional metal material particle gas generated in the hollow portion 21A is, through the hollow portion 21A and the gas output flanges 14b, 14c, ejected into the CVD chamber 200.

The processing object material 18 is placed in the CVD chamber 200, as described above. Therefore, the processing object material 18 is exposed to the functional metal material particle gas thus generated, so that a film of the functional metal material particles, such as an oxide film, a nitride film, or the like, is formed on the processing object material 18. A heat treatment is performed on the formed film, to cause fine crystal growth. Thereby, a highly functional insulating film is obtained.

As seen from the descriptions thus far given, combined use of the plasma generation apparatus 100 and the CVD chamber 200 provides a film formation process apparatus of remote plasma type (a CVD apparatus of remote plasma type) that is able to generate a large amount of functional metal material particle gas in a very effective manner.

Next, effects of the invention of this embodiment will be described.

In the plasma generation apparatus 100 according to this embodiment having the above-described configuration, a contact between the plasma excitation gas ejected through the ejection holes 21x of the insulating tube 21 and the metal precursor gas supplied from the precursor supply part 201 is caused in the hollow portion 21A of the insulating tube 21. Dissociation of the metal precursor gas into metal particles and modification such as oxidation or nitriding of the metal particles themselves are promoted.

The contact of the plasma excitation gas with the metal precursor gas promotes dissociation of the metal precursor gas into metal particles in the hollow portion 21A. Moreover, a chemical reaction between the metal particles resulting from the dissociation and the plasma excitation gas occurs in the hollow portion 21A. As a result, a large amount of functional metal material particle gas which is nitrided, oxidized, or the like, can be efficiently generated in the hollow portion 21A.

The reaction between the metal precursor gas and the plasma excitation gas is caused not in the CVD chamber 200 side but in the plasma generation apparatus 100 side in which the plasma excitation gas is generated. This enables the metal precursor gas to react with the plasma excitation gas having a higher concentration. Therefore, a larger amount of functional metal material particle gas can be generated more efficiently. The functional metal material particle gas is efficiently led to the CVD chamber 200.

The functional metal material gas that has been already generated in the plasma generation apparatus 100 side is supplied to the CVD chamber 200. In the invention according to this embodiment, the functional metal material gas that has been already generated is supplied to the CVD chamber 200. This can improve the speed of film formation on the processing object material 18 and can increase the quality of the formed film, as compared with a case where a metal precursor gas is directly supplied into the CVD chamber 200 and a reaction between the metal precursor gas and the plasma excitation gas is caused in the CVD chamber 200 to thereby generate a functional metal material gas.

Since the metal precursor gas is not directly supplied to the CVD chamber 200, complication of a structure of the CVD chamber 200 side and a sequence for controlling operation conditions can be prevented.

In the plasma generation apparatus 100 according to this embodiment, the metal precursor gas is directly supplied into the insulating tube 21, and therefore the metal precursor gas does not pass through the discharge space 6. Accordingly, in the plasma generation apparatus 100 having the above-described configuration, occurrence of a situation in which the metal precursor gas is exposed to plasma in the discharge space 6 can be prevented, too. Therefore, the plasma generation apparatus 100 can prevent the properties of the metal precursor gas from being impaired by plasma.

In the plasma generation apparatus 100 according to this embodiment, the pressure difference ΔP (=Pa-Pb) is generated between the discharge space 6 and the hollow portion 21A. The pressure difference ΔP enables the generated plasma excitation gas to be ejected at a high speed through the ejection ports 21x into the hollow portion 21A of the insulating tube 21 that is located in a central region of the electrode cell and that has been vacuumed.

This can suppress occurrence of collision among the plasma excitation gases in a region from the discharge space 6 to the hollow portion 21A, and also suppress occurrence of collision of the plasma excitation gas with a wall and the like. Therefore, the amount of attenuation caused by collisions of the plasma excitation gas can be suppressed. This enables the plasma excitation gas to be more efficiently extracted into the hollow portion 21A. As a result, the plasma excitation gas and the metal precursor gas supplied into the insulating tube 21 can be efficiently brought into contact.

In the invention of this embodiment, the pressure reducer 27 is able to set the pressure in the hollow portion 21A of the insulating tube 21 to a vacuum state which is equal to or less than40kPa (300 Torr). Accordingly, the plasma excitation gas ejected into the hollow portion 21A that is in the vacuum state collides with the metal precursor gas supplied into the hollow portion 21A while collision among the plasma excitation gases is suppressed. Such collision causes a chemical reaction or the like, so that the metal precursor gas is changed into a functional metal material gas. The functional metal material gas is supplied into the CVD chamber 200. Therefore, the amount of attenuation caused by collision among the plasma excitation gases can be reduced. As a result, the concentration and the flow rate of the plasma excitation gas can be kept high. Therefore, the plasma excitation gas can be efficiently brought into contact with the functional metal material gas.

In the invention according to this embodiment, the plasma excitation gas is generated in the electrode cell by using the dielectric barrier discharge which is atmospheric pressure discharge. Due to the pressure difference ΔP, the generated plasma excitation gas can be ejected from the discharge space 6 through the ejection holes 21x into the hollow portion 21A that is in the vacuum state.

As understood from the above, in the invention according to this embodiment, discharge under the atmospheric pressure is achieved in the discharge space provided in the housing 16 of the plasma generation apparatus 100. Thus, the invention according to this embodiment is able to generate a large amount of plasma excitation gas with a high concentration by means of the plasma generation apparatus 100 having a simple configuration. The generated plasma excitation gas is ejected into the hollow portion 21A that in the vacuum state, while the amount of attenuation of the plasma excitation gas caused by collision or the like is suppressed.

In this embodiment, the small ejection holes 21x are formed through the insulating tube 21. Accordingly, entry of charged particles generated in the discharge space 6 into the hollow portion 21A of the insulating tube 21 can be suppressed.

The plasma generation apparatus 100 according to this embodiment includes the pipe passage 75 that is not connected to a space within the housing 16 where the electrode cells are not arranged and that directly supplies the source gas from the housing 16 into each discharge space 6.

Accordingly, the source gas can be directly supplied through the pipe passage 75 into each discharge space 6 without containing a space within the housing 16 other than the discharge space 6. Therefore, separately from the inert gas and the like supplied from the gas supply part 20, the active gas, the metal precursor gas, and the like, can be supplied as the source gas through the pipe passage 75 into the discharge space 6.

Normally, use of an active gas and a metal precursor gas as the source gas can effectively generate a large amount of plasma excitation gas by means of dielectric barrier discharge. However, it deteriorates a peripheral part within an apparatus other than a discharge part because of corrosion, deposition of metal precursor particles, and the like. This shortens the lifetime of the apparatus.

Therefore, as illustrated in this embodiment, the source gas is directly supplied through the pipe passage 75 into the discharge space 6 without contacting a space within the housing 16 other than the discharge space 6. This can prevent the active gas from contacting a component part such as the electrode cell, and can prevent a peripheral part within the apparatus from being deteriorated because of corrosion by the active gas. Since the metal precursor gas is directly supplied to the discharge space 6, deposition caused by the metal precursor gas in a space within the housing 16 other than the discharge space 6 can be prevented, too. Thus, the lifetime of the apparatus can be prolonged.

In the plasma apparatus 100 according to the present invention, troubles such as the corrosion and the deposition do not occur. This allows the active gas and the metal precursor gas to be supplied as the source gas to dielectric barrier discharge. Therefore, a large amount of plasma excitation gas can be generated.

In order to prevent corrosion of the pipe passage 75 (including the parts 75a and 75b) through which the activated gas is supplied, it is desirable that a passive film having a corrosion resistance is provided to the inner wall of the pipe passage 75 (including the parts 75a and 75b). In order to prevent occurrence of a dew condensation of the metal precursor gas in the pipe passage 75 (including the parts 75a and 75b), it is desirable to provide a temperature adjuster for adjusting and keeping the temperature within the pipe passage 75 (including the parts 75a and 75b). For example, a passage through which a liquid whose temperature has been adjusted flows is provided in the connection block 9 and in the low-voltage electrode 1.

In the invention of the present application, a film formation processing apparatus of remote plasma type is provided. That is, the plasma generation apparatus 100 that generates the plasma excitation gas from the source gas and the CVD chamber 200 that performs the film formation process on the processing object material 18 by using the generated plasma excitation gas are separate and different apparatuses.

Since a plasma generation source and a film formation processing region are completely separated, occurrence of collision of charged particles such as ions or electrons generated by dissociation in the plasma source with the processing object material 18 arranged in the processing region can be prevented. Thus, a large amount of plasma excitation gas having a high concentration, alone or together with a functional metal material particle gas which is nitrided, oxidized, or the like, can be brought into contact with the processing object material 18. This can completely eliminate damages to the processing object material 18 caused by plasma. Thus, a film can be efficiently formed. Additionally, a large amount of plasma excitation gas having a high concentration, alone or together with a functional metal material particle gas which is nitrided, oxidized, or the like, is supplied to the CVD chamber 200, and thereby a plasma CVD process is performed in the CVD chamber 200. This can shorten the time period for formation of a film on the processing object material 18.

In the plasma generation apparatus 100 according to this embodiment, each discharge space 6 is connected to the auto pressure controller 26 via the pipe passage 22 that exists between the insulating tube 21 and an end portion of the discharge space 6 at the outlet side. Moreover, the pressure of the discharge space 6 is controlled to a constant value near the atmospheric pressure.

Accordingly, it is easy for the plasma generation apparatus 100 to regulate and keep the pressure of each discharge space 6 to a constant value. Since the plasma generation apparatus 100 is configured to regulate the pressure of the discharge space 6 to a desired pressure, it is easy to regulate, set, and keep the pressure so as to optimize the performance of generation of the plasma excitation gas. In the plasma generation apparatus 100, the dielectric barrier discharge can be generated under a state where the pressure in each discharge space 6 is kept constant. Therefore, in each discharge space 6, the plasma excitation gas having a uniform excitation level is generated. As a result, a highly functional film having a higher quality is formed on the processing object material 18 in the CVD chamber 200.

In the plasma generation apparatus 100 according to this embodiment, the passage through which the cooling medium whose temperature has been adjusted to a constant temperature flows is formed in the low-voltage electrode 1.

Accordingly, heat generated in the electrode cell due to the dielectric barrier discharge can be dissipated through the cooling medium, so that the temperature of the low-voltage electrode 1 itself can be easily regulated and kept to the constant temperature. Additionally, since the low-voltage electrode 1 is kept to the constant temperature, the temperature in each discharge space 6 can be also easily regulated and kept to the constant temperature. For example, the temperature in each discharge space 6 is regulated and set so as to optimize the performance of generation of the plasma excitation gas. In the plasma generation apparatus 100, the dielectric barrier discharge can be caused under a state where the temperature in each discharge space 6 is set constant. Thus, a plasma excitation gas having a uniform excitation level is generated in each discharge space 6. Therefore, a highly functional film having a higher quality is formed on the processing object material 18 in the CVD chamber 200.

The plasma generation apparatus 100 according to this embodiment includes not only the gas MFC 24 but also the sub gas MFC 25 that outputs the rare gas. The source gas and the rare gas, which are mixed, are supplied from the gas supply part 20 into the housing 16.

Accordingly, even when various mix gases are adopted as the source gas, the effect that the plasma excitation gas can be efficiently generated by dielectric barrier discharge is exerted. Thus, a variety of functional metal material particle gases can be obtained easily. The rare gas is also guided through the discharge space 6 to the hollow portion 21A having the vacuum pressure. Therefore, in a path through which the plasma excitation gas ejected toward the hollow portion 21A moves, the rare gas suppresses attenuation of active species, which may be caused by collision among plasma excitation gases. This increases the concentration and flow rate of the plasma excitation gas. That is, the plasma excitation gas can be efficiently extracted into the insulating tube 21.

In the plasma generation apparatus 100 according to this embodiment, a plurality of electrode cells are provided, and the electrode cells are stacked in the direction in which they face each other. The stack of electrode cells have, at a central region thereof, the continuous through hole extending in the stacking direction. In the continuous through hole, the insulating tube 21 extending in the stacking direction is arranged.

Accordingly, a plasma excitation gas can be generated from the plurality of electrode cells, and the generated plasma excitation gas can be caused to join together in the hollow portion 21A of the insulating tube 21. This enables the plasma excitation gas having a high flow rate to be extracted in the hollow portion 21A. Since the electrode cells are stacked in the vertical direction of FIGS. 1 and 2, it is possible to considerably increase the amount of generated plasma excitation gas without increasing the area occupied by the plasma generation apparatus 100.

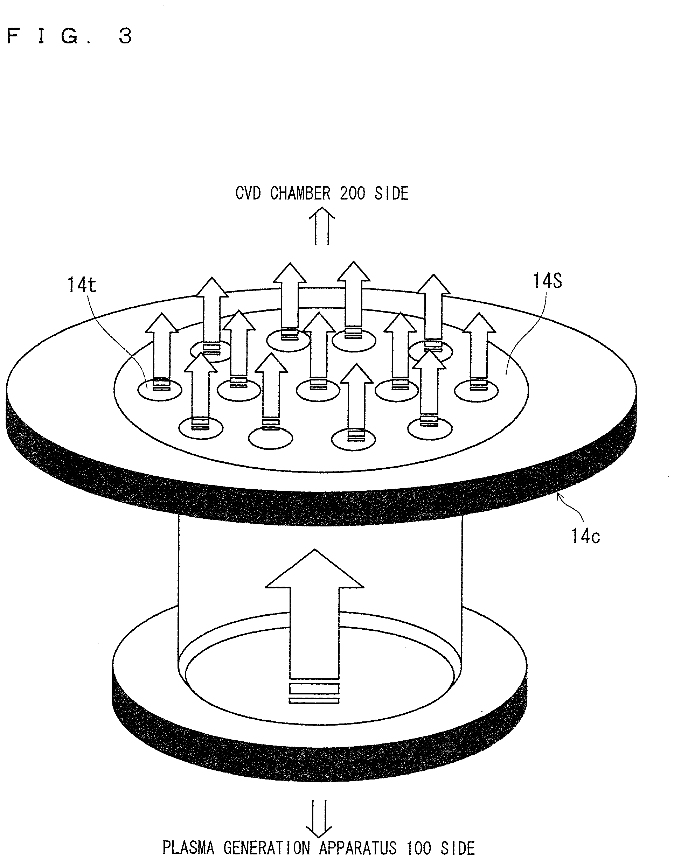

It may be acceptable that a shower plate is arranged at the end side of the insulating tube 21. To be more specific, a configuration shown in a perspective view on an enlarged scale of FIG. 3 may be adopted as the gas output flange 14c shown in FIG. 1 that is connected to the CVD chamber 200 side.

As shown in FIG. 3, the gas output flange 14c has a shower plate 14S. The shower plate 14S has a plurality of ejection holes 14t formed therethrough.

The functional metal material particle gas generated in the plasma generation apparatus 100 are ejected to the hollow portion 21A of the insulating tube 21, passes through the hollow portion 21A and the gas output flange 14b at the plasma generation apparatus 100 side, and reach the gas output flange 14c at the CVD chamber 200 side.

In the gas output flange 14c, a buffer chamber having a large capacity is provided adjacent to the shower plate 14S. Thus, in FIG. 3, an upper surface of the buffer chamber serves as the shower plate 14S.

The functional metal material particle gas reaches the gas output flange 14c, and in the gas output flange 14c, once permeates the buffer chamber having the large capacity. Then, the functional metal material particle gas is supplied from the buffer chamber into the CVD chamber 200 through the plurality of ejection holes 14t formed in the shower plate 14S.

Adoption of the gas output flange 14c having the configuration shown in FIG. 3 enables the functional metal material particle gas to be uniformly supplied from the ejection holes 14t of the shower plate 14S into the CVD chamber 200. Accordingly, even when the processing object material 18 having a large area is placed in the CVD chamber 200, a surface of the processing object material 18 having the large area can be uniformly exposed to the functional metal material particle gas (the functional metal material particle gas can be uniformly ejected to surface of the processing object material 18 having the large area). The uniform ejection of the functional metal material particle gas allows a highly functional insulating film having a high quality to be uniformly formed on the surface of the processing object material 18 having the large area.

In the description give above, the precursor supply part 201 supplies the metal precursor gas to the hollow portion 21A of the insulating tube 21. Instead, the precursor supply part 201 may supplied, to the hollow portion 21A of the insulating tube 21, not only the metal precursor gas but also an activated gas based on nitrogen or oxygen (which can be regarded as an active gas including at least any element from oxygen and nitrogen). The metal precursor gas and the activated gas supplied from the supply pipe passage 201A are, through the flange portion 201B, supplied to the hollow portion 21A of the insulating tube 21.

The precursor supply part 201 supplies the activated gas to the hollow portion 21A of the insulating tube 21. Thereby, the dissociation of the metal precursor gas into the metal particles caused in the hollow portion 21A and the chemical reaction between the metal particles resulting from the dissociation and the plasma excitation gas caused in the hollow portion 21A, are promoted. This can efficiently generate a large amount of functional metal material particle gas which is nitrided, oxidized, or the like, in the hollow portion 21A.

### <Embodiment 2>

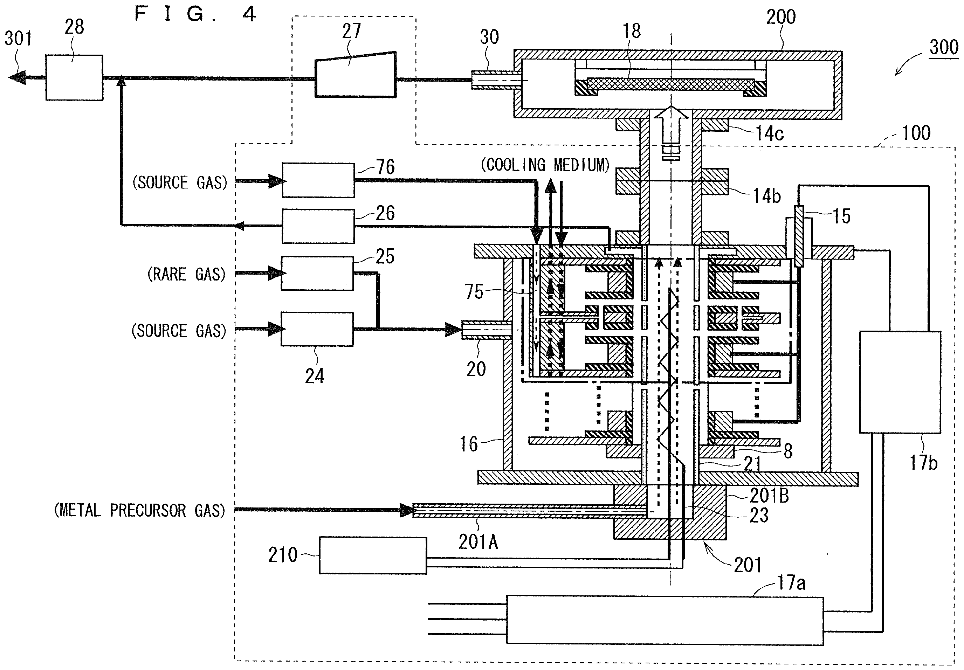

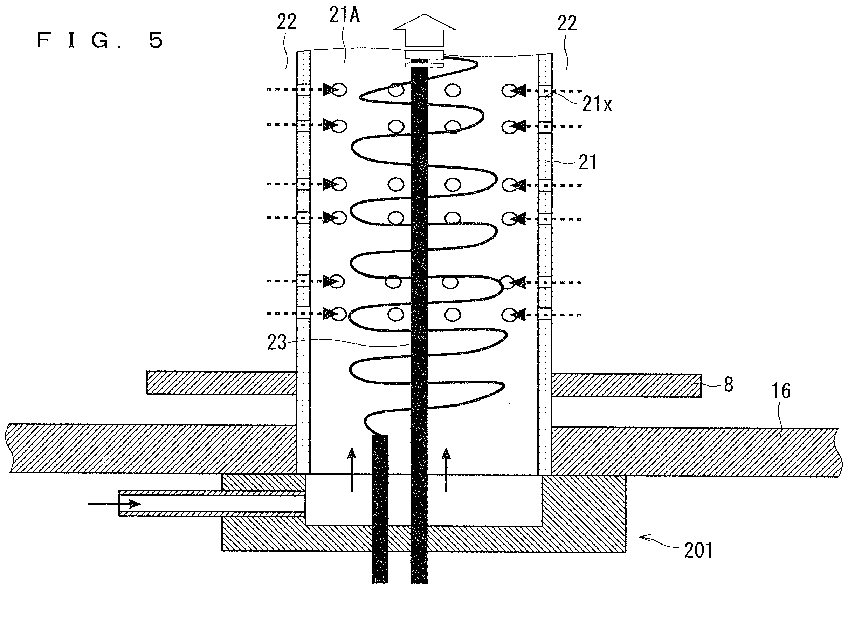

FIG. 4 is a cross-sectional view showing a configuration of a CVD apparatus 300 according to this embodiment. FIG. 5 is a cross-sectional view showing, on an enlarged scale, an internal configuration of the insulating tube 21 shown in FIG. 4. In the configuration shown in FIG. 5, for simplification of the drawing, the configurations around the insulating tube 21 (the electrodes 1, 3, the dielectrics 2a, 2b, the discharge space 6, the insulators 1a, 3a, 5a, the high-pressure cooling plate 5, the insulating plate 4, and the like) are not illustrated.

As shown in FIGS. 4 and 5, a plasma generation apparatus according to this embodiment includes a metal catalyst filament 23. The metal catalyst filament 23 is arranged in the hollow portion 21A of the insulating tube 21 having the vacuum pressure. More specifically, the metal catalyst filament 23 is enclosed by the insulating tube 21 such that a side surface of the metal catalyst filament 23 is spaced apart at a predetermined interval from the insulating tube 21.

As shown in FIG. 4, a heater 210 is connected to the metal catalyst filament 23. The metal catalyst filament 23 is a metal filament having a high melting point. For example, tungsten, molybdenum, or zirconium is adoptable for the metal catalyst filament 23.

The metal catalyst filament 23 is arranged along a direction in which the hollow portion 21A of the insulating tube 21 extends. As shown in FIG. 4, the metal catalyst filament 23 is provided so as to extend over the substantially entire region of the hollow portion 21A with respect to the direction in which the electrode cells are stacked. The metal catalyst filament 23 faces openings of all the ejection holes 21x.

The heater 210 causes a predetermined current to flow in the metal catalyst filament 23, and thereby a surface of the metal catalyst filament 23 is heated up to, for example, about 1200°C. As described in the embodiment 1, the plasma excitation gas is supplied from the discharge space 6 and the metal precursor gas is supplied from the precursor supply part 201, into the hollow portion 21A in which the metal catalyst filament 23 thus heated is arranged.

In the plasma generation apparatus 100 according to this embodiment, the metal catalyst filament 23 is arranged in the hollow portion 21A of the insulating tube 21 to which the plasma excitation gas and the metal precursor gas are supplied.

Accordingly, when the surface of the metal catalyst filament 23 is heated to a high temperature, the metal precursor gas having come into contact with the surface of the metal catalyst filament 23 causes a catalytic chemical reaction. As a result, the dissociation of the metal precursor gas into metal particles is promoted in the hollow portion 21A. A contact between the metal particles resulting from the dissociation and the plasma excitation gas generated in the plasma generation apparatus 100 promotes a chemical reaction of the metal particles in the hollow portion 21A. Thus, a large amount of functional metal material particle gas which is nitrided, oxidized, or the like, can be generated more efficiently.

### <Embodiment 3>

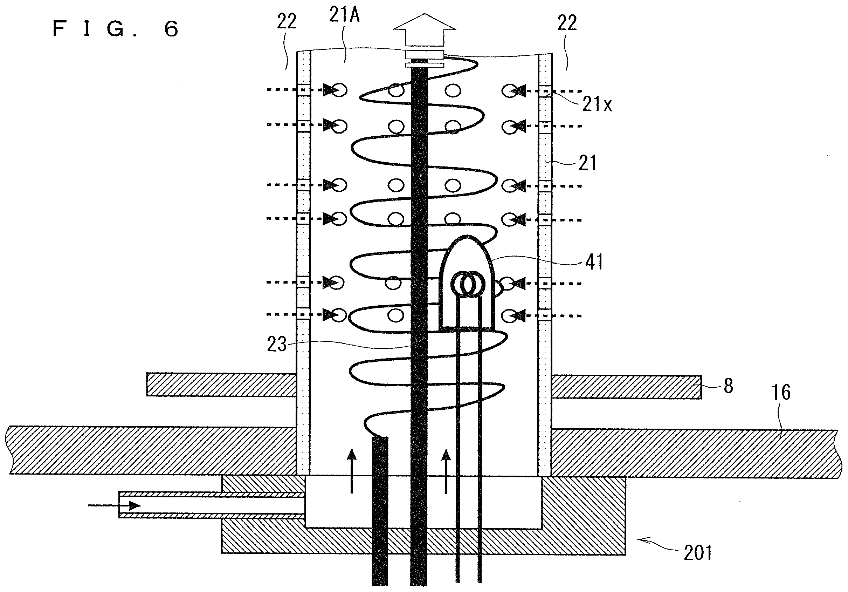

FIG. 6 is a cross-sectional view showing, on an enlarged scale, a plasma generation apparatus according to this embodiment. FIG. 6 shows an internal configuration of the insulating tube 21. In the configuration shown in FIG. 6, similarly to FIG. 5, for simplification of the drawing, the configurations around the insulating tube 21 (the electrodes 1, 3, the dielectrics 2a, 2b, the discharge space 6, the insulators 1a, 3a, 5a, the high-pressure cooling plate 5, the insulating plate 4, and the like) are not illustrated.

As seen from comparison between FIGS. 5 and 6, the plasma generation apparatus according to this embodiment includes a ultraviolet lamp 41 in addition to the metal catalyst filament 23. The ultraviolet lamp 41 is also arranged in the hollow portion 21A of the insulating tube 21. More specifically, the ultraviolet lamp 41 is enclosed by the insulating tube 21 such that a side surface of the ultraviolet lamp 41 is spaced apart at a predetermined interval from the insulating tube 21. The ultraviolet lamp 41 emits ultraviolet light having a wavelength of 400 nm or less.

The heater 210 causes a predetermined current to flow in the metal catalyst filament 23, and thereby a surface of the metal catalyst filament 23 is heated. On the other hand, the ultraviolet lamp 41 emits light having a specific wavelength. As described in the embodiment 1, the plasma excitation gas is supplied from the discharge space 6 and the metal precursor gas is supplied from the precursor supply part 201, into the hollow portion 21A in which the metal catalyst filament 23 thus heated and the ultraviolet lamp 41 thus emitting light are arranged.

In the plasma generation apparatus 100 according to this embodiment, not only the metal catalyst filament 23 but also the ultraviolet lamp 41 is arranged in the hollow portion 21A of the insulating tube 21 to which the plasma excitation gas and the metal precursor gas are supplied.

Accordingly, the metal precursor gas having come into contact with the surface of the heated metal catalyst filament 23 causes a photocatalytic chemical reaction as well as the heat catalytic chemical reaction. Since the photocatalytic chemical reaction can be used, the dissociation of the metal precursor gas into metal atoms is promoted in the hollow portion 21A while the temperature (for example, about 800°C) to which the metal catalyst filament 23 is heated is suppressed low. This can more efficiently generate a larger amount of functional metal material particle gas which is nitrided, oxidized, or the like, in the hollow portion 21A.

Desirably, a reflecting surface is formed over the entire side surface of the insulating tube 21. The reflecting surface is a mirror surface capable of causing the ultraviolet light emitted from the ultraviolet lamp 41 to diffusely reflect within the insulating tube 21. The reflecting surface is formed by, for example, a thin film of gold, platinum, or aluminum, being applied, vapor-deposited, or printed on an entire inside surface of the insulating tube 21.

Forming such a reflecting surface on the insulating tube 21 enables the ultraviolet light emitted from the ultraviolet lamp 41 to uniformly propagate throughout the hollow portion 21A. Therefore, the above-mentioned photocatalytic chemical reaction can be used in a uniform manner within the hollow portion 21A.

While the invention has been shown and described in detail, the foregoing description is in all aspects illustrative and not restrictive. It is therefore understood that numerous modifications and variations not illustrated herein can be devised without departing from the scope of the invention which is defined by the claims.

### DESCRIPTION OF THE REFERENCE NUMERALS

- 1: low-voltage electrode
- 1a, 3a, 5a: insulator
- 2a, 2b: dielectric
- 3: high-voltage electrode
- 4: insulating plate
- 5: high-pressure cooling plate
- 6: discharge space
- 8: fastening plate
- 9: connection block
- PH: pass-through
- 14b, 14c: gas output flange
- 14S: shower plate
- 14t: ejection hole
- 15: electricity supply terminal
- 16: housing
- 17: AC power source
- 17a: inverter
- 17b: high-voltage transformer
- 18: processing object material
- 20: gas supply part
- 21: insulating tube
- 21A: hollow portion
- 21x: ejection hole
- 22: pipe passage
- 23: metal catalyst filament
- 24,76: gas MFC
- 25: sub gas MFC
- 26: auto pressure controller
- 27: pressure reducer
- 28: exhaust gas decomposition processor
- 30: exhaust gas output port
- 41: ultraviolet lamp
- 75: pipe passage
- 75a: buffer
- 75b: ejection port
- 100: plasma generation apparatus
- 200: CVD chamber
- 201: precursor supply part
- 201A: supply pipe passage
- 201B: flange portion
- 210: heater
- 300: CVD apparatus

## Claims

1. A plasma generation apparatus comprising:
an electrode cell (1, 2a, 2b, 3);
a power source part (17) configured to apply an AC voltage to said electrode cell;
a housing (16) that encloses said electrode cell; and
a source gas supply part (20) configured to supply a source gas from the outside of said housing into said housing,
said electrode cell including:
a first electrode (3);
a second electrode (1) facing said first electrode so as to form a discharge space (6);
a dielectric (2a ,2b) arranged on at least either one of a main surface of said first electrode facing said discharge space and a main surface of said second electrode facing said discharge space; and
a pass-through (PH) formed in a central portion of said electrode cell in a plan view, said pass-through penetrating said electrode cell with respect to a facing direction in which said first electrode and said second electrode face each other,
said plasma generation apparatus further comprising:
an insulating tube (21) having a cylindrical shape and arranged in said pass-through, said insulating tube including an ejection hole (21x) that is formed in a side surface of said cylindrical shape; and
a precursor supply part (201) connected to a hollow portion (21A) of said insulating tube from the outside of said housing and configured to supply a metal precursor.

2. The plasma generation apparatus according to claim 1, further comprising:
a metal catalyst filament (23) arranged in said hollow portion of said insulating tube; and
a heater (210) configured to heat said metal catalyst filament.

3. The plasma generation apparatus according to claim 2, further comprising a ultraviolet lamp (41) arranged in said hollow portion of said insulating tube.

4. The plasma generation apparatus according to claim 3, wherein
a reflecting surface is formed on said insulating tube, said reflecting surface being configured to cause ultraviolet light emitted from said ultraviolet lamp to diffusely reflect within said insulating tube.

5. The plasma generation apparatus according to claim 1 or 2, further comprising a pressure control device (26) configured to keep a pressure of said discharge space to a constant value.

6. The plasma generation apparatus according to claim 1 or 2, wherein
a passage through which a cooling medium flows is formed in said second electrode.

7. The plasma generation apparatus according to claim 1 or 2, wherein
said source gas supply part is configured to supply said source gas together with a rare gas.

8. The plasma generation apparatus according to claim 1 or 2, wherein
said precursor supply part is configured to supply, to said hollow portion of said insulating tube, an active gas including at least any element from oxygen and nitrogen.

9. The plasma generation apparatus according to claim 1 or 2, wherein
said electrode cell comprises a plurality of electrode cells,
said electrode cells are stacked in said facing direction.

10. The plasma generation apparatus according to claim 9, further comprising a shower plate (14S) arranged at an end portion side of said insulating tube.

11. A CVD apparatus comprising:
a plasma generation apparatus according to claim 1; and
a CVD chamber (200) connected to said plasma generation apparatus,
said CVD chamber being connected to an end portion of said insulating tube.

12. The CVD apparatus according to claim 11, wherein
said plasma generation apparatus further comprises:
a metal catalyst filament (23) arranged in said hollow portion of said insulating tube; and
a heater (210) configured to heat said metal catalyst filament.

## Patentansprüche

1. Plasmaerzeugungseinrichtung, umfassend:
eine Elektrodenzelle (1, 2a, 2b, 3);
ein Energiequellenteil (17), das konfiguriert ist, um eine Wechselspannung an die Elektrodenzelle anzulegen;
ein Gehäuse (16), das die Elektrodenzelle umschließt; und
ein Quellgasversorgungsteil (20), das konfiguriert ist, um ein Quellgas von der Außenseite des Gehäuses in das Gehäuse zu liefern,
wobei die Elektrodenzelle Folgendes beinhaltet:
eine erste Elektrode (3);
eine zweite Elektrode (1), die der ersten Elektrode zugewandt ist, um einen Entladungsraum (6) zu bilden;
ein Dielektrikum (2a, 2b), das auf mindestens einer der Hauptoberfläche der ersten Elektrode, die dem Entladungsraum zugewandt ist, und einer Hauptoberfläche der zweiten Elektrode, die dem Entladungsraum zugewandt ist, angeordnet ist; und
einen Durchgang (PH), der in einem zentralen Abschnitt der Elektrodenzelle in einer Draufsicht ausgebildet ist, wobei der Durchgang die Elektrodenzelle in Bezug auf eine sich zugewandte Richtung durchdringt, in der sich die erste Elektrode und die zweite Elektrode einander zuwenden,
wobei die Plasmaerzeugungseinrichtung weiter umfasst:
ein Isolierrohr (21), das eine zylindrische Form aufweist und in dem Durchgang angeordnet ist, wobei das Isolierrohr ein Auswurfloch (21x) beinhaltet, das in einer Seitenoberfläche der zylindrischen Form ausgebildet ist; und
ein Vorläufer-Versorgungsteil (201), das mit einem hohlen Abschnitt (21A) des Isolierrohrs von der Außenseite des Gehäuses verbunden und konfiguriert ist, um einen Metallvorläufer zu liefern.

2. Plasmaerzeugungseinrichtung nach Anspruch 1, weiter umfassend:
ein Metallkatalysatorfilament (23), das in dem hohlen Abschnitt des Isolierrohres angeordnet ist; und
eine Heizvorrichtung (210), die konfiguriert ist, um das Metallkatalysatorfilament zu erwärmen.

3. Plasmaerzeugungseinrichtung nach Anspruch 2, weiter umfassend eine Ultraviolettlampe (41), die in dem hohlen Abschnitt des Isolierrohrs angeordnet ist.

4. Plasmaerzeugungseinrichtung nach Anspruch 3, wobei
eine reflektierende Oberfläche auf dem Isolierrohr ausgebildet ist, wobei die reflektierende Oberfläche konfiguriert ist, um zu bewirken, dass das von der Ultraviolettlampe emittierte Ultraviolettlicht innerhalb des Isolierrohrs diffus reflektiert wird.

5. Plasmaerzeugungseinrichtung nach Anspruch 1 oder 2, weiter umfassend eine Drucksteuervorrichtung (26), die konfiguriert ist, um einen Druck des Entladungsraums auf einem konstanten Wert zu halten.

6. Plasmaerzeugungseinrichtung nach Anspruch 1 oder 2, wobei
in der zweiten Elektrode ein Durchgang ausgebildet ist, durch den ein Kühlmedium strömt.

7. Plasmaerzeugungseinrichtung nach Anspruch 1 oder 2, wobei
das Quellgaszufuhrteil konfiguriert ist, um das Quellgas zusammen mit einem Edelgas zu liefern.

8. Plasmaerzeugungseinrichtung nach Anspruch 1 oder 2, wobei
das Vorläufer-Zuführungsteil konfiguriert ist, um dem hohlen Abschnitt des Isolierrohres ein aktives Gas zu liefern, das mindestens ein Element aus Sauerstoff und Stickstoff beinhaltet.

9. Plasmaerzeugungseinrichtung nach Anspruch 1 oder 2, wobei
die Elektrodenzelle eine Vielzahl von Elektrodenzellen umfasst,
wobei die Elektrodenzellen in der gegenüberliegenden Richtung gestapelt sind.

10. Plasmaerzeugungseinrichtung nach Anspruch 9, weiter umfassend eine Duschplatte (14S), die an einer Endabschnittsseite des Isolierrohres angeordnet ist.

11. CVD-Einrichtung, umfassend:
eine Plasmaerzeugungseinrichtung nach Anspruch 1; und
eine CVD-Kammer (200), die mit der Plasmaerzeugungseinrichtung verbunden ist,
wobei die CVD-Kammer mit einem Endabschnitt des Isolierrohres verbunden ist.

12. CVD-Einrichtung nach Anspruch 11, wobei
die Plasmaerzeugungseinrichtung weiter umfasst:
ein Metallkatalysatorfilament (23), das in dem hohlen Abschnitt des Isolierrohrs angeordnet ist; und
eine Heizvorrichtung (210), die konfiguriert ist, um das Metallkatalysatorfilament zu erhitzen.

## Revendications

1. Appareil de génération de plasma comprenant :
une cellule d'électrodes (1, 2a, 2b, 3) ;
une partie source d'alimentation électrique (17) configurée pour appliquer une tension alternative à ladite cellule d'électrodes ;
un logement (16) qui entoure ladite cellule d'électrodes ; et
une partie d'alimentation en gaz source (20) configurée pour alimenter un gaz source provenant de l'extérieur dudit logement dans ledit logement,
ladite cellule d'électrodes incluant :
une première électrode (3) ;
une seconde électrode (1) orientée vers ladite première électrode afin de former un espace de décharge (6) ;
un diélectrique (2a, 2b) agencé sur au moins l'une ou l'autre parmi une surface principale de ladite première électrode orientée vers ledit espace de décharge et une surface principale de ladite seconde électrode orientée vers ledit espace de décharge ; et
un passage traversant (PH) formé dans une partie centrale de ladite cellule d'électrodes dans une vue en plan, ledit passage traversant pénétrant dans ladite cellule d'électrodes par rapport à une direction de face à face dans laquelle ladite première électrode et ladite seconde électrode sont l'une en face de l'autre,
ledit appareil de génération de plasma comprenant en outre :
un tube isolant (21) ayant une forme cylindrique et agencé dans ledit passage traversant, ledit tube isolant incluant un trou d'éjection (21x) qui est formé dans une surface latérale de ladite forme cylindrique ; et
une partie d'alimentation en précurseur (201) raccordée à une partie creuse (21A) dudit tube isolant à partir de l'extérieur dudit logement et configurée pour alimenter un précurseur de métal.

2. Appareil de génération de plasma selon la revendication 1, comprenant en outre :
un filament catalytique métallique (23) agencé dans ladite partie creuse dudit tube isolant ; et
un dispositif chauffant (210) configuré pour chauffer ledit filament catalytique métallique.

3. Appareil de génération de plasma selon la revendication 2, comprenant en outre une lampe à ultraviolets (41) agencée dans ladite partie creuse dudit tube isolant.

4. Appareil de génération de plasma selon la revendication 3, dans lequel
une surface réfléchissante est formée sur ledit tube isolant, ladite surface réfléchissante étant configurée pour amener une lumière ultraviolette émise par ladite lampe à ultraviolets à se réfléchir par diffusion au sein dudit tube isolant.

5. Appareil de génération de plasma selon la revendication 1 ou 2, comprenant en outre un dispositif de régulation de pression (26) configuré pour maintenir une pression dudit espace de décharge à une valeur constante.

6. Appareil de génération de plasma selon la revendication 1 ou 2, dans lequel un passage à travers lequel un milieu de refroidissement s'écoule est formé dans ladite seconde électrode.

7. Appareil de génération de plasma selon la revendication 1 ou 2, dans lequel
ladite partie d'alimentation en gaz source est configurée pour fournir ledit gaz source conjointement avec un gaz rare.

8. Appareil de génération de plasma selon la revendication 1 ou 2, dans lequel
ladite partie d'alimentation en précurseur est configurée pour alimenter, dans ladite partie creuse dudit tube isolant, un gaz actif incluant au moins un quelconque élément parmi l'oxygène et l'azote.

9. Appareil de génération de plasma selon la revendication 1 ou 2, dans lequel
ladite cellule d'électrodes comprend une pluralité de cellules d'électrodes,
lesdites cellule d'électrodes sont empilées dans ladite direction de face à face.

10. Appareil de génération de plasma selon la revendication 9, comprenant en outre une plaque de douche (14S) agencée d'un côté de partie d'extrémité dudit tube isolant.

11. Appareil CVD comprenant :
un appareil de génération de plasma selon la revendication 1 ; et
une chambre CVD (200) raccordée audit appareil de génération de plasma,
ladite chambre CVD étant raccordée à une partie d'extrémité dudit tube isolant.

12. Appareil CVD selon la revendication 11, dans lequel
ledit appareil de génération de plasma comprend en outre :
un filament catalytique métallique (23) agencé dans ladite partie creuse dudit tube isolant ; et
un dispositif chauffant (210) configuré pour chauffer ledit filament catalytique métallique.
